# EUROPÄISCHE PATENTSCHRIFT

(11) **EP 0 536 355 B1**
(45) Veröffentlichungstag und Bekanntmachung des Hinweises auf die Patenterteilung: **21.08.1996**
(21) Anmeldenummer: 92908161.0
(22) Anmeldetag: 10.04.1992
(51) Int. Cl.: C23C 16/26, C23C 4/12, C23C 16/50

(54) **VERFAHREN ZUM AUFBRINGEN EINER BESCHICHTUNG AUF EIN SUBSTRAT**
PROCESS FOR APPLYING A COATING TO A SUBSTRATE
PROCEDE POUR APPLIQUER UN REVETEMENT SUR UN SUBSTRAT

(30) Priorität: 13.04.1991 DE 4112156
(43) Veröffentlichungstag der Anmeldung: 14.04.1993
(73) Patentinhaber: Fried. Krupp AG Hoesch-Krupp, D-45143 Essen (DE)
(72) Erfinder: LUGSCHEIDER, Erich, D-5100 Aachen (DE); WEBER, Thomas, D-4030 Ratingen (DE); SCHLUMP, Wolfgang, D-4300 Essen 1 (DE)
(86) Internationale Anmeldenummer: EP9200816
(87) Internationale Veröffentlichungsnummer: WO9218664

(56) Entgegenhaltungen:
- EP-A- 0 469 204
- EP-A- 0 481 722
- FUJITSU-SCIENTIFIC AND TECHNICAL JOURNAL. Bd. 25, Nr. 1, 1989, KAWASAKI JP Seiten 44 - 51; KURIHARA ET AL.: 'Diamond-film synthesis using DC plasma jet CVD'
- CHEMICAL ABSTRACTS, vol. 113, no. 12, 17. September 1990, Columbus, Ohio, US; abstract no. 106941Z, KAWARADA ET AL.: 'Diamond-coated hard metals and coating process therefor' Seite 670 ;
- FUJITSU-SCIENTIFIC AND TECHNICAL JOURNAL. Bd. 25, Nr. 1, 1989, KAWASAKI JP, Seiten 44-51

## Beschreibung

Die Erfindung betrifft ein Verfahren zum Aufbringen einer Beschichtung auf ein Substrat mit Hilfe eines Plasmabrenners.

Beschichtungen werden zur Verbesserung der Eigenschaften eines bestimmten Grundwerkstoffes in den unterschiedlichsten Anwendungen eingesetzt. Eine Möglichkeit der Aufbringung einer Beschichtung ist das sog. CVD-Verfahren, bei dem eine Abscheidung eines oder zweier Elemente aus der Gasphase vorgenommen wird, die im Augenblick des Auftreffens auf ein Substrat kondensiert. Bei zwei Elementen handelt es sich stets um einfache Verbindungen, die in einer gekoppelten Reaktion gebildet werden. Als Beispiel für eine derartige CVD-Beschichtung sei Titancarbid genannt, wobei die Ausgangsgase Methan und Titantetrachlorid sind, die zum Titancarbid und HCl reagieren. HCl wird abgeführt.

Eine andere Möglichkeit, Beschichtungen auf ein Substrat aufzubringen, ist das Plasmaspritzen, also ein thermisches Spritzen, bei dem in einem Plasmabrenner Temperaturen bis zu 20.000 K erzeugt werden, um einen als Pulver oder Draht zugeführten Schichtwerkstoff aufzuschmelzen und auf das Substrat auftreffen zu lassen. Die für die Beschichtung eingesetzten Plasmabrenner werden in erster Linie mit Argon und zu einem geringen Teil mit Wasserstoff oder Helium als Betriebsgas zur Erzeugung des Plasmas betrieben, wobei zwischen einer Anode und einer Kathode innerhalb des Plasmabrenners ein Gleichstrom angelegt wird; das Plasma kann auch über ein elektromagnetisches Hochfrequenzwechselfeld erzeugt werden. Ein Beispiel für einen Plasmabrenner ist z.B. in der Zeitschrift "Werkstatt und Betrieb" Jahrgang 1984, Seite 339, beschrieben. Der zugeführte Draht bzw. das zugeführte Pulver kann vorlegiert sein, so daß die kompliziertesten Verbindungen, Gemische und Strukturen aufgespritzt werden können, und zwar Metalle ebenso wie Keramikwerkstoffe oder Gemische daraus.

Bei vielen Anwendungsfällen besteht die mit einem Plasmabrenner aufgebrachte Beschichtung aus einem Verbundwerkstoff, der aus einer Matrix als Nutzschicht einerseits und Einlagerungen zur Verbesserung der Matrixeigenschaften andererseits besteht. Die Matrix und die Einlagerungen werden dem Plasmabrenner als Pulver zugegeben. Dabei kann durch die Variation der Pulverzugabe während des Beschichtungsaufbaus auch eine Gradierung erreicht werden, also eine Veränderung der Konzentration der Einlagerungen von einer Stelle unmittelbar an der Oberfläche des Substrates bis zu einer Stelle der Oberfläche der späteren Beschichtung. Ein typischer Werkstoff für eine derartige Matrix ist z.B. eine Nickel-Chrom-Legierung mit Chromcarbiden als Einlagerungen.

In neuerer Zeit ist es gelungen, reine Diamantbeschichtungen auf ein Substrat aufzubringen, was insbesondere in der Elektronikindustrie Bedeutung hat. Ein entsprechendes Verfahren ist in der europäischen Patentanmeldung 90106785.0 eingehend beschrieben. Der für die Diamantpartikel erforderliche Kohlenstoff wird durch ein kohlenstoffhaltiges Gas oder eine Flüssigkeit dem Plasmastrahl zugefügt, wobei mit Hilfe von Wasserstoff und einem Inertgas dafür gesorgt wird, daß sich die Kohlenstoffanteile als Diamant- bzw. diamantähnliche Stoffe ablagern und nicht als Graphit. Es handelt sich also um ein CVD-Verfahren, bei dem aus einer gasförmigen Phase Diamentkristalle durch Kondensation abgeschieden werden.

Der Nutzen von reinen Diamantüberzügen liegt in erster Linie in der hervorragenden elektrischen Isolierung und in der hervorragenden Wärmeleitung des Diamanten. Damit bildet der Diamant ideale Voraussetzungen für Kühlkörper, auf denen thermisch hochbelastete elektronische Bauteile aufgebracht werden. Selbstverständlich ist auch die Härte von Diamantüberzügen in der industriellen Anwendung von Interesse, beispielsweise als Verschleißschutz. Allerdings ist eine ausreichende Haftung auf dem Grundwerkstoff nicht leicht zu erreichen.

Die europäische Patentanmeldung 90308570.2 beschreibt ein Verfahren und eine Vorrichtung zum Aufbringen von Diamantschichten nach dem CVD-Verfahren. Zur Verbesserung der Haftung der Diamantschichten werden Schichtaufbauten unter Zuhilfenahme einer oder mehrerer Zwischenschichten vorgestellt, wobei darauf geachtet wird, daß zwischen benachbarten Schichten eine entsprechende Verträglichkeit vorhanden ist, um insbesondere einen unterschiedlichen Ausdehnungskoeffizienten zwischen Substrat und Diamantwerkstoff zu beherrschen. Die Zwischenschichten werden mit derselben Vorrichtung aufgebracht, mit der auch die Diamantschicht aufgebracht wird.

Darüberhinaus werden Beschichtungen offenbart, die aus Zweiphasensysstemen unter Einschluß von Kohlenstoff zur Diamantbildung bestehen, die ebenfalls nach dem CVD-Verfahren aufgebracht werden. Dabei dient das eine gasförmige Element als Kohlenstoffträger, während das andere gasförmige Element eine Keimbildung unterstützt, wobei expressis verbis Platin, Nickel, Cobalt, Eisen, Wolfram, Silicium Molybdän und Titan genannt sind. Diese Elemente werden als feines Pulver in das Plasma eingebracht und verdampft. Aufgrund der angegebenen Betriebsparameter von 10 bis 70 Ampere und 50 bis 150 Volt kann das Plasma im Bereich einer nicht im thermischen Gleichgewicht befindlichen Glimmentladung angesiedelt werden, was im übrigen zu der Offenbarung in der europäischen Patentanmeldung 90106785.0 paßt, gemäß der die Abscheidung von der Diamantmodifikation aus einem Kohlenstoffträger bei einer "stummen" Entladung erfolgen muß. Es handelt sich dabei also ebenso um ein Plasma in der unteren Energiestufe. Dem gleichen Typ der CVD-Verfahren sind auch Chemical Abstracts, vol. 113, No. 12, Abstract No. 106941z und Patent Abstracts of Japan, vol. 14, No. 171 (C-706)3 und JP-A-02 022 471, Fujitsu Scientific and Technical Journal, Vol. 25, 1989, Seiten 44-51, EP-A-O 469 204 und EP-A-0 481 722 zuzuordnen. Auch die erstgenannte dieser Veröffentlichungen beschreibt ein Verfahren zur Herstellung von Diamantschichten, bei dem ein Substrat mittels eines Plasmabrenners - unter Verwendung einer Zwischenschicht - durch Synthese auf der Oberfläche des betreffenden Bauteils mit Diamant beschichtet wird.

Es ist Aufgabe der Erfindung, ein neuartiges Verfahren zur Aufbringung einer Beschichtung im thermischen Spritzverfahren vorzuschlagen, so daß eine aufgespritzte Beschichtung erzielbar ist, deren Eigenschaften sehr leicht innerhalb eines Spektrums variiert werden können, das von einer beinahe reinen Diamantbeschichtung mit der Matrix als Bindungswerkstoff bis zu der Matrix als Nutzschicht mit Diamanteinlagerungen zur Verbesserung der Eigenschaften der Nutzschicht reicht.

Die Erfindung ist in den Ansprüchen beschrieben, auf die hiermit ausdrücklich Bezug genommen wird. Bei einem derartigen Vorgehen wird im Gegensatz zu der bekannten Oberflächensynthese durch die infolge des thermischen Spritzens in Verbindung mit den anspruchsgemäßen weiteren Verfahrensschritten bereits in der Flugphase erfolgende Diamantsynthese eine Beschichtung erreicht, deren Zusammensetzung über einen breiten Spielraum auch über die Dicke ein und derselben Beschichtung frei wählbar, stetig und im Sinne einer graduellen Änderung variierbar ist.

Es hat sich überraschend gezeigt, daß auch in einem sehr energiereichen, im thermischen Gleichgewicht befindlichen Plasma, das innerhalb eines Plasmabrenners zum thermischen Spritzen vorherrscht, eine Reaktionskette abläuft, die ebenfalls zu einer Abscheidung von Diamantpartikeln führt, obwohl keine stille Entladung oder Glimmentladung zur Bereitstellung der Energie vorhanden ist, sondern ein Potential, das bezüglich des Energieinhaltes um eine bis eineinhalb Potenzen höher liegt. Offensichtlich kommt es auch bei diesem energiereichen Plasma infolge einer Dissoziierung der Moleküle des Kohlenstoffträgers zur Bildung von Radikalen, die äußerst reaktionsstark sind. Das führt dazu, daß am Ende der Plasmaflamme im wesentlichen alle Radikale neue Verbindungen eingehen werden, so daß die Radikalenkonzentration am Ende der Flamme gegen Null geht, in einem kürzeren Abstand zur Plasmabrennerdüse jedoch wesentlich höher ist. Wenn zur Abscheidung von Diamanten auf einem Substrat z.B. Methan (CH₄) eingesetzt wird, sind die Radikale CH₃-Atome und Wasserstoffatome, die offenbar eine große Rolle dabei spielen, ob ein Kohlenstoffatom beim Auftreffen auf das Substrat in der Graphitmodifikation oder in der Diamantenmodifikation auskristallisiert.

Ein weiterer Faktor, der über die auskristallisierende Modifikation mit entscheidet, ist die Zusammensetzung des Pulvers zur Bildung der Matrix, also der Nutzschicht bzw. des reinen Bindungswerkstoff, der ein völlig herkömmlicher Plasmaspritzstoff sein kann. Die Zugabe von Carbidbildnern, wie z.B. Titan, Chrom, Hafnium oder Zirkon, führt zur Abbindung des freien Kohlenstoffs zu Carbiden, der nicht zu Diamant synthetisiert. Der nicht zu Diamant synthetisierende Kohlenstoff kann außerdem gelöst werden, beispielsweise durch die Zugabe von Cobalt. Es sei darauf hingewiesen, daß diese Beeinflussung der Auskristallisierung des Kohlenstoffs zu der Diamantmodifikation nicht durch eine gasförmige Phase des verdampften Pulvers erreicht wird, sondern daß die Reaktion mit dem lediglich aufgeschmolzenen Pulver stattfindet.

Die Erfindung schlägt nun erstmals vor, das Verhältnis zwischen Diamantpartikeln und Matrix nach Belieben zu variieren, wobei das eine Extrem durch eine fast reine Diamantschicht mit der Matrix als Bindungswerkstoff und das andere Extrem durch eine Matrix mit feinst verteilten Diamantpartikeln von nur wenigen Prozent verkörpert wird; dazwischen kommen alle Mischformen vor, also auch Anwendungsfälle, bei denen sowohl die Diamantpartikel einen direkten Nutzanteil als auch die Matrix einen direkten Nutzanteil haben. Es hat sich nämlich gezeigt, daß reine Diamantschichten auf dem Substrat schlecht haften und in sich nur einen unzureichenden Verbund aufweisen, so daß eine Nutzung der Diamanthärte bei dynamischer Beanspruchung so gut wie nicht möglich ist. Die Erfindung umfaßt daher lediglich in einer Matrix eingebundene Diamantpartikel, wobei selbstverständlich der Bindungswerkstoff einen sehr geringen Anteil haben kann, so lange er fein verteilt ist.

Wenn eine Beschichtung erzeugt werden soll, die einen hohen Diamantanteil und einen geringen Matrixanteil haben soll, muß das Substrat relativ nahe an die Plasmabrennerdüse herangerückt werden, weil an dieser Stelle die Radikalenkonzentration am höchsten ist. Die hohe Radikalenkonzentration sorgt dann dafür, daß sich die Kohlenstoffatome in der Diamantmodifikation auf dem Substrat abscheiden. Diese Abscheidung wird immer wieder durchdrungen von Matrixbestandteilen, die sich einmal als Haftgrund auf das Substrat setzen und im übrigen alle Diamantpartikel allseitig benetzen. Infolge der großen Nähe des Substrates zu der Plasmabrennerdüse erwärmt sich das Substrat sehr stark, es sei denn, es wird beispielsweise durch eine rückwärtige Anordnung intensiv gekühlt, was durch Kaltgasduschen, Sprühen, Anlegen von gekühlten Platten oder durch eine direkte Durchströmung durch das Substrat bewirkt werden kann.

Wenn der Anteil an Matrix innerhalb der Beschichtung gesteigert werden soll, wird das Substrat in eine Zone geringerer Radikalenkonzentration innerhalb der Plasmabrennerflamme gebracht, wobei dann zunehmend Carbidbildner dem Matrixwerkstoff in der Ausgangsform als Pulver zugesetzt werden müssen. Die Carbidbildner wie z. B. Titan, Chrom, Hafnium oder Zirkon sorgen dafür, daß sich der überschüssige Kohlenstoff nicht als Graphit abscheidet, sondern mit den genannten Carbidbildnern Carbide bildet, die ihrerseits hervorragende Verschleißeigenschaften haben und so neben den dispergierten Diamantpartikeln zur Verschleißbeständigkeit der Beschichtung beitragen. Im Einzelfall kann entschieden werden, welcher der Carbidbildner ausgewählt wird, wobei es insbesondere auf die Verträglichkeit mit der Matrix ankommt. Alternativ kann neben der simultanen Diamantsynthese und Spritzbeschichtung auch jeder Teilprozeß in zeitlicher Folge abwechselnd gefahren werden, also abwechselnd als Beschichtung reiner Matrixwerkstoff oder reiner Diamant als Hartstoff abgeschieden werden.

Zum Betreiben des Plasmabrenners wird insbesondere ein Gleichstromlichtbogen eingesetzt. Dadurch wird das Anwendungsspektrum von aufgespritzten Beschichtungen gemäß der Erfindung drastisch erweitert. Für die Verweilzeit der einzelnen Komponenten innerhalb des Plasmabrenners kann es zweckmäßig sein, statt eines Gleichstromlichtbogens ein Hochfrequenzwechselfeld zur Erzeugung des Plasmas einzusetzen. Eine weitere Möglichkeit, die Verweilzeit zu verbessern, liegt darin, an dem entsprechenden Plasmabrenner für die Zufuhr des kohlenstoffhaltigen Gases oder der Flüssigkeit einen axialen Kanal vorzusehen, durch den diese Komponente im Zentrum des Brenners eingegeben wird. Außerdem besteht dann keine Gefahr des Zuwachsens dieses Kanals, weil die Reaktion mit den übrigen Komponenten erst nach dem Austritt beginnt. Im Nebeneffekt wird dadurch die Kathode mitgekühlt.

Die Beschichtungen gemäß der Erfindung werden vorzugsweise in einem Druckbereich unterhalb des Atmosphärendruckes verwirklicht. Aber auch im Bereich oberhalb des Atmosphärendruckes können befriedigende Ergebnisse erzielt werden, wobei die Abstände vorangehend schon erläutert worden sind. In der Praxis werden Abstände des Substrats von der Plasmabrennerdüse von 6 bis 20 cm praktiziert. Selbstverständlich kann eine Gashülle aus einem Inertgas zum Schutz der aufgebrachten Beschichtung während der Entstehung und unmittelbar nach der Entstehung zweckmäßig sein, was für sich gesehen bekannt ist und mit Hilfe von Ringdüsen um die Lavaldüse des Plasmabrenners bewerkstelligt werden kann. Für höhere Drücke bis 5 bar und für unteratmosphärische Drücke bis 50 mbar ist selbstverständlich eine Kammer für das Substrat erforderlich, deren Innendruck geregelt wird. Der Anwendungsbereich schließt eine Unterflüssigkeitsbeschichtung, z.B. in Wasser, ausdrücklich mit ein.

In jüngster Zeit ist es gelungen, sog. Fullerene herzustellen, also eine neue Modifikation des Kohlenstoffs, bei der ein als Kugel geformter Cluster von 60 oder 70 Kohlenstoffatomen vorhanden ist. Auch diese Modifikation kann selbstverständlich als Nutzschicht oder als Einlagerung in eine Matrix verwendet werden, wenn entsprechende Eigenschaften gewünscht werden.

Das Besondere der Erfindung liegt darin, daß das thermische Plasmaspritzen mit der Synthetisierung von Diamanten kombiniert werden kann, ohne die Variationsbreite zu verlieren, die durch das Plasmaspritzen hinsichtlich der auftragbaren Schichten ermöglicht wird. Die Parameter zum Betreiben eines Plasmabrenners mit einem Gleichstromlichtbogen liegen dabei im üblichen Rahmen, es werden also bei einer Spannung von ca. 100 V, die bis 500 V im Einzelfall reichen kann, eine Stromstärke bis zu 1000 A erreicht, wobei Pulvermengen bis zu 5 kg/ Stunde bei 50 bis 300 l/min an Argon verbraucht werden. Die typische Korngröße für das zugeführte, gegebenenfalls vorlegierte Pulver liegt im Bereich von 5 bis 100 µm.

Beschichtungen aus oxidationsbeständigen Legierungen oder heißgasbeständigen Legierungen oder korrosionsbeständigen Legierungen können zur Verbesserung der Härte mit Diamanten als Eigenschaftsverbesserer aufgespritzt werden, nämlich z.B. M-Cr-Al-Y-Legierungen, wobei der Buchstabe M für die Elemente Eisen, Cobalt und/oder Nickel steht. Verschleiß- und korrosionsbeständige Legierungen sowie reine Hartlegierungen auf Eisen-, Cobalt- oder Nickelbasis können ebenso unter Beimengungen von Diamanten verspritzt werden, wie reine Cobalthartstofflegierungen, die z.B. unter der kommerziellen Bezeichnung Stellite bekannt sind. Für ähnliche Zwecke werden Nickelhartlegierungen verwendet, die Nickel, Chrom, Bor und Silcium enthalten. Darüberhinaus können selbstverständlich Hartmetalle gespritzt werden auf Wolframcarbid-Cobalt-Basis, auf Wolfram-Titancarbid/ Tantalcarbid-Cobalt-Basis oder auf Nickel-Chromcarbid-Basis. Auch diesen Hartmetallen können Diamantmodifikationen zugemischt werden, um die Eigenschaften zu verändern.

Die vorgenannten spritzbaren Beschichtungen sind lediglich beispielhaft genannt auf dem Gebiet des Korrosions- und Verschleißschutzes. Wegen der sehr hohen Energie beim Plasmaspritzen können auch oxidkeramische und nichtoxidkeramische Werkstoffe verspritzt werden, die mit Molybdän vermischt sein können, die unter der Bezeichnung Cermet bekannt sind. Spritzbar sind also alle reinen Oxide und Mischoxide sowie Multikomponentenoxide, die jeweils gemäß der Erfindung mit dem Diamantwerkstoff modifizierbar sind. Hier sind auch Silikate zu nennen, die unter der Bezeichnung Cordierit bekannt sind.

Selbst bei Beschichtungen zur Bioverträglichkeit, wo Phosphate verspritzt werden, die auch unter der Bezeichnung Hydroxyl-Apatit bekannt sind, kann es im Einzelfall zweckmäßig sein, Diamanteinlagerungen in unterschiedlicher Verteilung und Dichte einzubringen, um wiederum das Verschleißverhalten zu verbessern. Das gilt auch für spritzbare intermetallisches Phasen binärer, ternärer oder noch höherer Systeme z.B. auf Nickel-Aluminium-, Titanbasis und dergleichen mehr. Schließlich kann es bei dem Aufspritzen von Schwermetallen und Kontaktwerkstoffen im Einzelfall vorteilhaft sein, verschleißmindernden Diamanthartstoff als Einlagerung zu haben, was mit Hilfe der Erfindung ohne weiteres verwirklicht werden kann.

Die vorangehenden Beispiele lassen erkennen, welche Bandbreite an Anwendungsfällen das thermische Plasmaspritzen ermöglicht, wobei nun infolge der Erfindung erstmals Diamanteinlagerungen bzw. fast reine Diamantschichten in Verbindung mit diesen Matrices ermöglicht werden. Immer kommt es darauf an, daß für die Abscheidung des Kohlenstoffes in der Diamantmodifikation ausreichend günstige Parameter beibehalten werden, was jedoch im genannten Rahmen kein Problem ist.

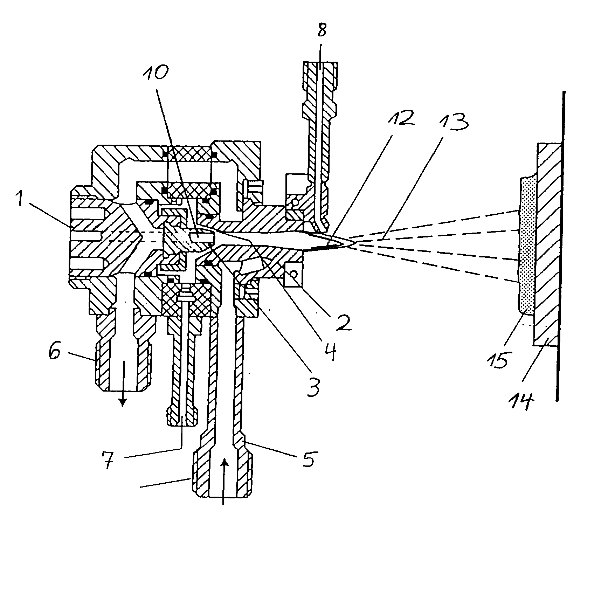

Nachfolgend wird ein Ausführungsbeispiel eines Plasmabrenners zur Durchführung des erfindnugsgemäßen Verfahrens, der in der Zeichnung dargestellt ist, näher erläutert; die einzige Figur der Zeichnung zeigt:
einen Querschnitt durch einen schematisch dargestellten Plasmabrenner zur Hervorbringung einer Beschichtung gemäß der Erfindung.

Der dargestellte Plasmabrenner besteht aus einem Grundkörper 1, an dem, elektrisch isoliert voneinander, eine Anode 2 und eine Kathode 3 angebracht sind. Zwischen beiden Eletroden befindet sich eine Lichtbogenzone 4, in der die elektrische Entladung entsteht, die Voraussetzung zur Bildung eines Plasmas ist. Wegen der hohen Temperaturbelastung wird der Brenner mit Hilfe eines Kühlwasserzulaufs 5 und eines Kühlwasserablaufs 6 im Durchfluß gekühlt, wobei gleichermaßen Anode 2 und Kathode 3 erreicht werden. Über einen gesonderten Betriebsgasanschluß 7 wird Argon oder ein Argonwasserstoffgemisch zugeführt. Am vorderen Ende der Anode 2 befindet sich eine Pulverzuführung 8 zum Eingeben des Matrixwerkstoffes sowie der Werkstoffe der Einlagerungen in die Plasmaflamme 12.

Der Grundkörper 1 sowie die Kathode 3 sind mit einem axialen Kanal 10 versehen, durch den ein kohlenstoffhaltiges Gas wie z.B. Methan oder eine kohlenstoffhaltige Flüssigkeit wie z.B. ein Alkohol in die Reaktionszone des Plasmabrenners eingebracht wird. Diese Komponente enthält den Kohlenstoff, aus dem später der dispergierte Diamanthartstoff entsteht. Statt durch den axialen Kanal 10 kann das Methan auch über das Pulverinjektorrohr, also die Pulverzuführung 8 in das Plasma eingeleitet werden. Alle an der Beschichtung beteiligten Komponenten verlassen als Spritzstrahl 13 den Plasmabrenner und treffen auf ein Substrat 14 auf, auf dem sich die Beschichtung 15 bildet.

Der Plasmabrenner zusammen mit dem Substrat 14 kann in einer Unterdruckkammer untergebracht sein, die nicht näher dargestellt ist. Diese wird fortlaufend auf einem vorgegebenen Druck gehalten, beispielsweise auf einem Druck von 50 mbar. Wegen des fortlaufend nachströmenden Plasmas muß also diese Unterdruckkammer durch fortlaufendes Abpumpen auf diesem Druck gehalten werden. Die Einbringung des Plasmabrenners und des Substrates 14 in eine Unterdruckkammer ist jedoch nicht Bedingung, da die erfindungsgemäße Beschichtung auch unter Atmosphärendruck oder unter noch höherem Druck hervorgebracht werden kann.

Das für den Betrieb des Plasmabrenners benötigte Betriebsgas ist Argon oder ein sonstiges Edelgas mit einem bestimmten Anteil von Wasserstoff. Der Wasserstoff hat die Eigenschaft, bereits gebildeten Graphit bei der Schichtbildung wegzuätzen, so daß die Anwesenheit von Wasserstoff ebenfalls zur Reduzierung des Graphitanteils beiträgt. Diese Erscheinungen sind jedoch für sich gesehen bekannt.

Die Beschichtung gemäß der Erfindung gelingt selbstverständlich auch dann, wenn der Kohlenstoffträger in Form eines Gases oder einer Flüssigkeit wie z.B. Alkohol in die Plasmaflamme 12 eingegeben wird, beispielsweise in oder gegenüber der Pulverzuführung 8. Es ist dann in jedem Fall sichergestellt, daß sich in der Lavaldüse innerhalb der Anode 2 keine Ablagerungen bilden können.

Das Besondere an der Erfindung ist die große Variationsmöglichkeit der Beschichtung durch Verändern der Parameter. Auf der einen Seite wird das Substrat mehr oder minder stark in die Zone einer hohen Radikalenkonzentration gebracht, zum anderen wird im Bereich niedriger Radikalenkonzentrationen ein Carbidbildner in den Matrixwerkstoff eingegeben, der neben dem Wasserstoff für die Ausscheidung des Kohlenstoffs, der nicht in der Diamantmodifikation kondensiert, sorgt. Bei einer Anordnung des Substrats in einer Zone hoher Radikalenkonzentration muß das Substrat in der Regel gekühlt werden, was jedoch kein ernsthaftes Hindernis ist. Die einfachste Möglichkeit der Substratkühlung ist das Plasmaspritzen unter Wasser.

Mit dem erfindungsgemäßen Verfahren kann selbstverständlich auch eine Gradierung erzielt werden, also eine Veränderung des Verhältnisses zwischen Matrix und Hartstoffeinlagerung gemessen über die Schichtdicke. Neben einer Gradierung zwischen Matrix und Einlagerung kann auch selbstverständlich eine mehrfache Gradierung vorhanden sein, also z.B. eine Wolfram-, Wolfram-Molybdän oder eine Vanadiumschicht gespritzt werden, die langsam in Titan oder Tantal übergeht, die wiederum die Matrix für die Diamantpartikel bilden. Abweichend davon kann auch zusätzlich zu dem Titan oder zu dem Tantal ein Übergang zu einem anderen Matrixwerkstoff gebildet werden, z.B. zu einem hochaktiven Carbidbildner, wobei dann die zuvor erwähnte Schicht als Sperrschicht dient. Im übrigen kann die Erfindung überall dort eingesetzt werden, wo eine Matrix mit gutem Erfolg auf ein Substrat aufgebracht werden kann, so daß Haftung, Porosität, Rißbildung und dgl. befriedigend ausfallen.

## Patentansprüche

1. Verfahren zum Aufbringen einer Beschichtung auf ein Substrat mit Hilfe eines Plasmabrenners als thermisches Spritzverfahren, bei dem die Beschichtung aus einer Matrix als Nutzschicht und Einlagerungen zur Verbesserung der Matrixeigenschaften oder aus einer Matrix als Bindematerial mit darin eingebundenen Partikeln besteht, die die eigentliche Nutzschicht bilden, mit den Schritten:
- Betreiben eines Plasmabrenners mit Pulverzufuhr zur Erzeugung der Matrix,
- Zuführen von kohlenstoffhaltigem Gas oder einer Flüssigkeit zu dem Plasmabrenner als reaktiver Bestandteil zur Bildung von diamantartigen, eingelagerten bzw. gebundenen Diamantpartikeln,
- Einjustieren des Abstandes des Substrates von der Plasmabrennerdüse für die Bemessung der Radikalenkonzentration der Plasmaflamme in unmittelbarer Nachbarschaft des Substrates, wobei ein geringer Abstand eine hohe und ein Abstand ca. in der Länge der Flamme eine niedrige Konzentration zur Folge hat,
- Beigabe von Karbidbildnern zu dem Pulver in Abhängigkeit des einjustierten Substratabstandes zu der Plasmabrennerdüse, wobei ein geringer Abstand eine geringe Beigabe und ein Abstand ca. in der Länge der Flamme eine vermehrte Beigabe bedingt,
- ggfs. Kühlen des Substrates bei geringen Abständen zu der Plasmabrennerdüse.

2. Verfahren nach Anspruch 1, bei dem das kohlenstoffhaltige Gas oder die Flüssigkeit zentral durch einen Kanal im Zentrum des Plasmabrenners oder radial zugeführt wird.

3. Verfahren nach Anspruch 1 oder 2, dadurch **gekennzeichnet**, daß dem Pulver ein kohlenstofflösendes Element zugegeben wird, beispielsweise Cobalt.

4. Verfahren nach einem der Ansprüche 1 bis 3, bei dem das Pulver für die Matrix ein metallisches, keramisches oder ein Gemisch daraus ist, also ein Cermet.

5. Verfahren nach Anspruch 1, bei dem als kohlenstoffhaltiges Gas Methan (CH₄) zugeführt wird.

6. Verfahren nach Anspruch 1, bei dem zur Vermeidung einer Graphitbildung Wasserstoff zusätzlich zu dem Betriebsgas des Plasmabrenners zugeführt wird.

7. Verfahren nach Anspruch 1, bei dem dem Plasmabrenner silicium-, stickstoff- und/oder borhaltige reaktive Gase zur Bildung entsprechender weiterer Einlagerungen zugeführt werden.

## Claims

1. Process for applying a coating to a substrate by means of a plasma burner in the form of a thermal spraying process, in which the coating is composed of a matrix as wear layer and inclusions for improving the matrix properties, or of a matrix as binding material with particles bonded therein, which form the actual wear layer, comprising the following steps:
- operation of a plasma burner with powder feed for the generation of a matrix;
- supply of gas containing carbon or of a liquid to the plasma burner as a reactive constituent for the formation of diamond-like, included or bonded diamond particles;
- adjustment of the distance of the substrate from the plasma burner nozzle for dimensioning the concentration of radicals in the plasma flame in the direct vicinity of the substrate, wherein a short distance results in a high concentration and a distance approximately along the length of the flame results in a low concentration;
- addition of carbide forming agents to the powder in dependence on the adjusted distance of the substrate from the plasma burner nozzle, wherein a short distance determines a small addition and a distance approximately along the length of the flame determines an increased addition;
- optional cooling of the substrate in the case of short distances from the plasma burner nozzle.

2. Process according to Claim 1, in which the gas containing carbon or the liquid is fed centrally through a duct in the centre of the plasma burner or radially.

3. Process according to Claim 1 or 2, characterised in that a carbon-releasing element, e.g. cobalt, is added to the powder.

4. Process according to one of Claims 1 to 3, in which the powder for the matrix is a metallic or ceramic powder, or a mixture thereof, i.e. a Cermet.

5. Process according Claim 1, in which methane (CH₄) is added as the gas containing carbon.

6. Process according to Claim 1, in which hydrogen is additionally added to the operating gas of the plasma burner to prevent graphite formation.

7. Process according to Claim 1, in which reactive gases containing silicon, nitrogen and/or boron are added to the plasma burner for the formation of corresponding further inclusions.

## Revendications

1. Procédé d'application d'un revêtement sur un substrat à l'aide d'un brûleur à plasma, sous la forme d'un procédé de pulvérisation thermique, dans le cas duquel le revêtement est constitué d'une matrice, comme couche d'usage, et d'inclusions pour améliorer les propriétés de la matrice, ou est constitué d'une matrice comme matériau de liaison comportant des particules intégrées à l'intérieur, qui forment la couche d'usage proprement dite, avec les mesures suivantes:
- exploitation d'un brûleur à plasma avec arrivée de poudre pour réalisation de la matrice,
- amenée, au brûleur à plasma, de gaz ou d'un liquide contenant du carbone et se présentant sous la forme d'un composé destiné à former des particules de diamant, du genre diamant, incluses ou englobées,
- ajustement de la distance entre le substrat et la buse du brûleur à plasma, pour déterminer la concentration en radicaux libres de la flamme du plasma au voisinage direct du substrat, une distance faible procurant une concentration élevée et une distance sensiblement de la longueur de la flamme procurant une concentration faible,
- l'apport à la poudre de corps carburants, en fonction de la distance ajustée entre le substrat et la buse du brûleur à plasma, une distance faible déterminant un faible apport, et une distance sensiblement de la longueur de la flamme déterminant un apport plus important,
- le cas échéant, refroidissement du substrat dans le cas de faibles distances jusqu'à la buse du brûleur à plasma.

2. Procédé suivant la revendication 1, dans le cas duquel le gaz ou le liquide contenant du carbone est amené au centre, par un canal situé au centre du brûleur à plasma, ou est y amené radialement.

3. Procédé suivant la revendication 1 ou la revendication 2, caractérisé en ce qu'à la poudre, est ajouté un élément dissolvant le carbone, par exemple du cobalt.

4. Procédé suivant l'une des revendications 1 à 3, caractérisé en ce que la poudre pour la matrice est une poudre métallique, céramique ou un mélange des deux, c'est-à-dire un cermet.

5. Procédé suivant la revendication 1, dans le cas duquel du méthane (CH₄) est envoyé comme gaz contenant du carbone.

6. Procédé suivant la revendication 1, dans le cas duquel, pour éviter la formation de graphite, de l'hydrogène est ajouté au gaz de fonctionnement du brûleur à plasma.

7. Procédé suivant la revendication 1, dans le cas duquel le brûleur à plasma est alimenté en gaz réactifs contenant du silicium, de l'azote et/ou du bore, pour former d'autres inclusions correspondantes.
